# EUROPEAN PATENT APPLICATION

(11) **EP 4 369 237 A1**
(43) Date of publication of application: **15.05.2024**
(21) Application number: 22290058.1
(22) Date of filing: 08.11.2022
(51) Int. Cl.: G06F 30/13, G06V 10/82, G06F 30/27, G06N 3/02, G06V 20/10, H02S 10/00, H02S 20/23

(54) **A METHOD FOR DETERMINING INSTALLATION CONSTRAINTS FOR THE INSTALLATION OF PHOTOVOLTAIC PANELS ON A ROOF OF A BUILDING**

(71) Applicant: TotalEnergies OneTech, 92400 Courbevoie (FR)
(72) Inventor: Albergel, M. Simon, 92400 COURBEVOIE (FR); Le Borgne, M. Emmanuel, 92400 COURBEVOIE (FR); Benhaiem, M. David, 92400 COURBEVOIE (FR); Perier, M. Thibault, 92400 COURBEVOIE (FR)
(74) Representative: Lavoix

(57) **Abstract**

The invention relates to a method for determining installation constraints for the installation of photovoltaic panels on a roof (R) of a building, the method comprising:
- a phase of building a training database (DB) associating an image seen from the sky of an area comprising, called building image (IM_{B}), with a roof mask (M_{R}) for each building of the building image (IM_{B}) and a roof category for each building of the building image (IM_{B}), and
- a phase of training a detection and classification model on the basis of the training database (DB) so as to obtain a trained model configured for determining a roof mask (M_{R}) and a roof category for each building imaged on an input image (IM).

## Description

### TECHNICAL FIELD OF THE INVENTION

The present invention concerns a method for determining installation constraints for the installation of photovoltaic panels on a roof of a building. The present invention also concerns an associated computer program product. The present invention also relates to an associated readable information carrier.

### BACKGROUND OF THE INVENTION

The scarcity of areas for the installation of photovoltaic sites pushes prospectors to look for entropized areas on which to deploy production assets.

In this context, rooftops represent an impressive potential. Therefore, prospectors are looking for additional information that will allow them to target the most interesting sites.

Among the indicators of interest, the type of roof can have an impact on the conditions of installation of photovoltaic panels and therefore on the feasibility and cost-effectiveness of a project.

However, such indicators are difficult to obtain and are not systematically taken into account.

### SUMMARY OF THE INVENTION

Hence, there exists a need for a method enabling to determine in a more precise way installation constraints for the installation of photovoltaic panels on a roof of building.

To this end, the invention relates to a method for determining installation constraints for the installation of photovoltaic panels on a roof of a building, the method comprising the following phases which are computer-implemented:
- a phase of building a training database, the training database associating an image seen from the sky of an area comprising at least one building having a roof, called building image, with a roof mask for each building of the building image and a roof category for each building of the building image, the roof category being chosen among a predetermined list of categories, each roof category implying specific installation constraints for the installation of photovoltaic panels,
- a phase of training a detection and classification model on the basis of the training database so as to obtain a trained model, the trained model having as input an image of an area seen from the sky and being configured for determining a roof mask and a roof category among the predetermined list of categories for each building imaged on the input image,

- a phase of operating the trained model comprising the following steps:
   - receiving an image of interest of an area seen from the sky, and
   - determining, by the trained model, a roof mask and a roof category for each building imaged on the image of interest, the determined roof category(ies) indicating installation constraints for the installation of photovoltaic panels on the corresponding roof(s).

The method according to the invention may comprise one or more of the following features considered alone or in any combination that is technically possible:
- the specific installation constraints for each roof category of the predetermined list of categories comprise at least a constraint relative to:
   - the hanging system of the photovoltaic panel on the roof, and/or
   - a treatment to be carried out on the roof before the installation of the photovoltaic panels;
- the method comprises a phase of displaying, on a display, the image of interest on which is superimposed the determined roof mask(s) and a data indicative of the roof category of each roof ;
- the trained model associates a confidence metric to each determined roof category;
- the phase of building the training database comprises the following steps :
   - collecting input data comprising: input images seen from the sky of areas comprising buildings having roofs, and a roof mask for each building of each input image,
   - cutting out the input images around each building, on the basis of the roof mask(s) of the input images, so as to obtain an image for each building, each obtained image forming a building image,
   - labelling each building image with a roof category, the roof category being selected among a predetermined list of categories, and
   - building the training database by associating each building image with the corresponding roof mask and the obtained roof category;
- the roof category for each building image is obtained using a labelling tool, the labelling tool being configured to display the building image on a display as well as the predetermined list of categories and to acquire the roof category selected by a user among the predetermined list of categories;
- the predetermined list of categories comprises at least the following categories: concrete-gravel flat roof, steel roof, roof made in fiber cement without asbestos, roof made in fiber cement with asbestos, tiles roof, and flat roofs;
- the method comprises a phase of determining an arrangement of photovoltaic panels on each roof imaged on the image of interest, the determination phase comprising:
   - a step of detecting obstacles on each roof of the image of interest by processing the image of interest using the corresponding roof mask(s), to obtain an obstacle mask for each roof of the image of interest, and
   - a step of determining an arrangement of photovoltaic panels on each roof of the image of interest as a function of the corresponding obstacle mask so that each photovoltaic panel covers a portion of the roof that is free of obstacles;
- the phase of determining an arrangement of photovoltaic panels comprises displaying, on a display, the image of interest on which is superimposed the determined arrangement of photovoltaic panels;
- the method comprises a phase of determining solar data relative to the arrangement of photovoltaic panels determined for each roof of the image of interest;
- the building images and the images of interest are images in the visible range acquired by a camera mounted on an aircraft;
- the detection and classification model is a convolutional neural network;
- the detection and classification model has been pretrained on a database different from the training database so as to achieve transfer learning.

The invention also relates to a computer program product comprising a readable information carrier having stored thereon a computer program comprising program instructions, the computer program being loadable onto a data processing unit and causing a method as previously described to be carried out when the computer program is carried out on the data processing unit.

The invention also relates to a readable information carrier on which is stored a computer program product as previously described.

### BRIEF DESCRIPTION OF THE DRAWINGS

The invention will be easier to understand in view of the following description, provided solely as an example and with reference to the appended drawings in which:
- Figure 1 is a schematic view of an example of a computer for implementing a method for determining installation constraints for the installation of photovoltaic panels on a roof of a building,
- Figure 2 is a schematic representation illustrating the implementation of phases of a method for determining installation constraints for the installation of photovoltaic panels on a roof of a building,
- Figure 3 is a schematic representation of an example of the building of a training database, and
- Figure 4 is a schematic representation of an example of some phases of the method for determining installation constraints for the installation of photovoltaic panels on a roof of a building.

### DETAILED DESCRIPTION OF SOME EMBODIMENTS

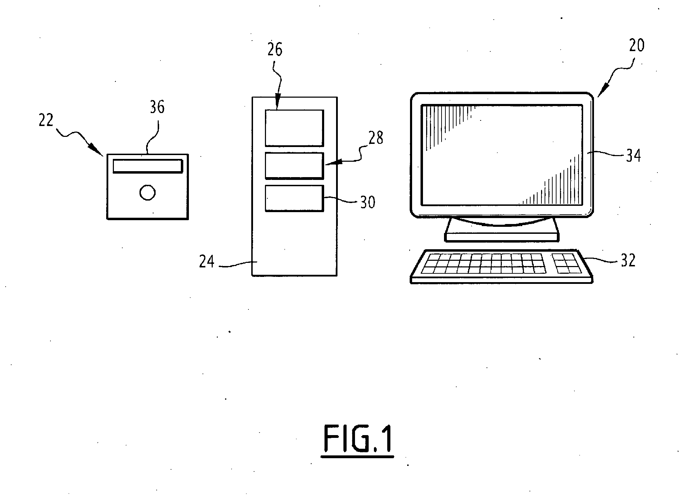

A computer 20 and a computer program product 22 are illustrated in figure 1.

The computer 20 is preferably a computer.

More generally, the calculator 20 is a computer or computing system, or similar electronic computing device adapted to manipulate and/or transform data represented as physical, such as electronic, quantities within the computing system's registers and/or memories into other data similarly represented as physical quantities within the computing system's memories, registers or other such information storage, transmission or display devices.

The calculator 20 interacts with the computer program product 22.

As illustrated on figure 1, the calculator 20 comprises a processor 24 comprising a data processing unit 26, memories 28 and a reader 30 for information media. In the example illustrated on figure 1, the calculator 20 comprises a human machine interface 32, such as a keyboard, and a display 34.

The computer program product 22 comprises an information medium 36.

The information medium 36 is a medium readable by the calculator 20, usually by the data processing unit 26. The readable information medium 36 is a medium suitable for storing electronic instructions and capable of being coupled to a computer system bus.

By way of example, the information medium 36 is a USB key, a floppy disk or flexible disk (of the English name "Floppy disc"), an optical disk, a CD-ROM, a magneto-optical disk, a ROM memory, a memory RAM, EPROM memory, EEPROM memory, magnetic card or optical card.

On the information medium 36 is stored the computer program 22 comprising program instructions.

The computer program 22 is loadable on the data processing unit 26 and is adapted to entail the implementation of a method for determining installation constraints for the installation of photovoltaic panels on a roof of a building, when the computer program 22 is loaded on the processing unit 26 of the calculator 20.

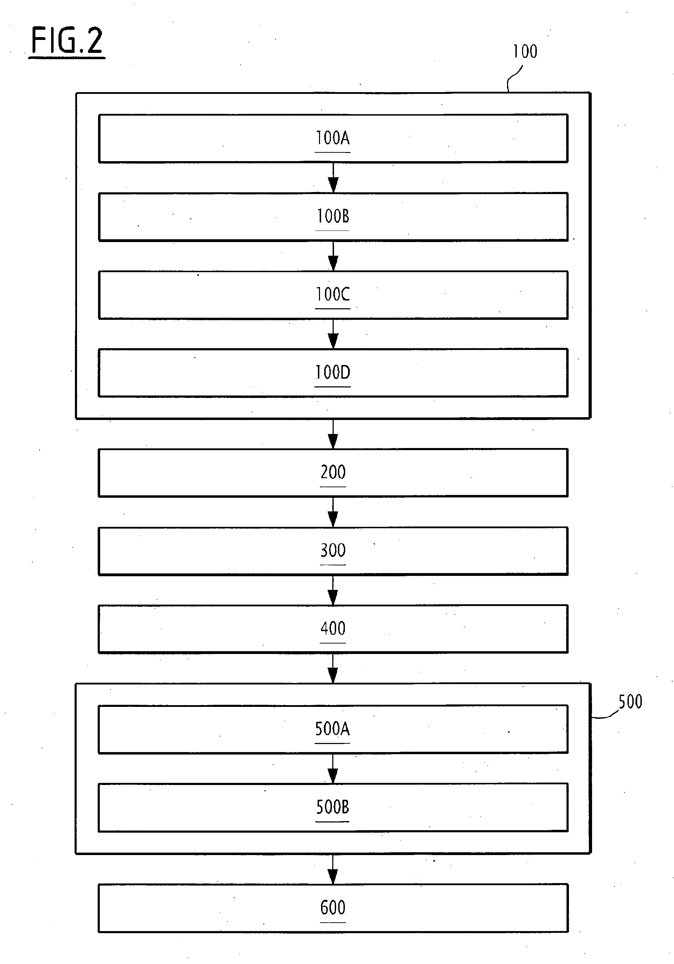

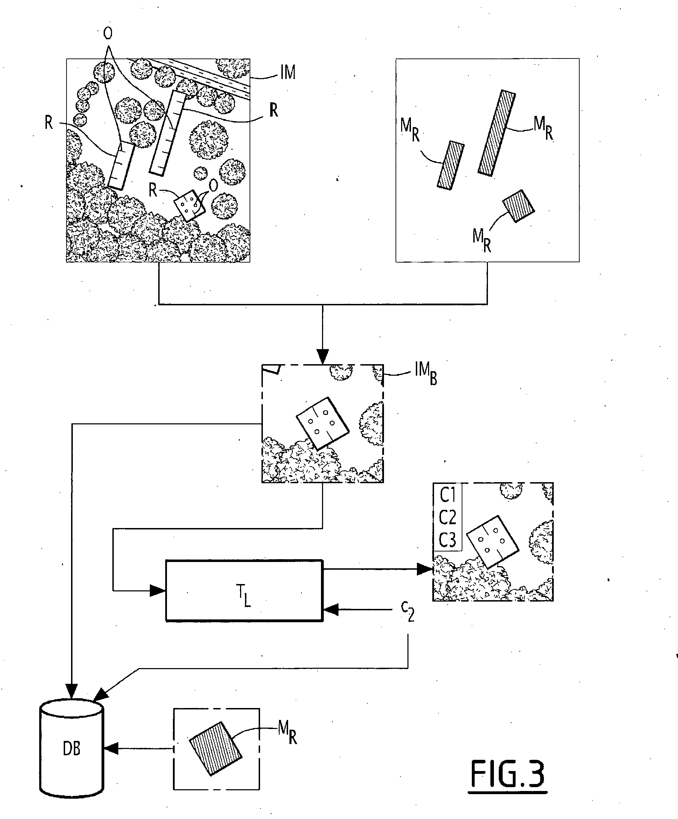

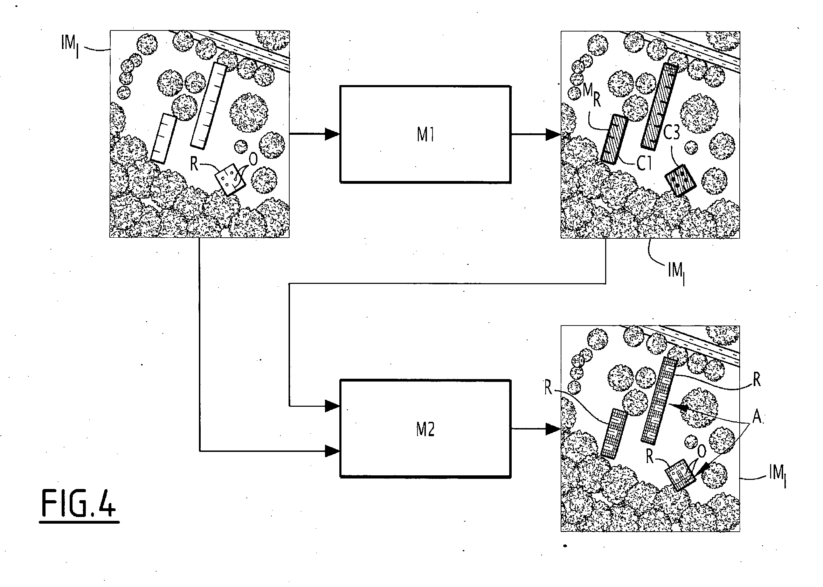

A method for determining installation constraints for the installation of photovoltaic panels on a roof R of a building, will now be described with reference to the organigram of figure 2, and to figures 3 and 4, which illustrate examples of some phases of this method.

Some obstacles O might be present on the roofs R. The term "obstacle" means an element present on the surface of the roof and incompatible with the placement of a photovoltaic panel on this element. Obstacles O are, for example, chimneys, windows (velux), air conditioning systems or vegetation (trees, plants).

The determination method comprises a phase 100 of building a training database DB. The building phase 100 is, for example, implemented by the calculator 20 interacting with the computer program product 22, that is to say is computer-implemented.

The training database DB associates an image seen from the sky of an area comprising at least one building having a roof R, called building image IM_{B}, with a roof mask M_{R} for each building of the building image IM_{B} and a roof category C_{R} for each building of the building image IM_{B}.

By the term "seen from the sky", it is understood that the images have been taken from an elevated view. For example, the building images IM_{B} have been acquired by a sensor, such as a camera mounted on an aircraft. In a variant, the building images IM_{B} are satellite images.

Preferably, the building images IM_{B} are images in the visible range (400 nanometers to 700 nanometers).

In an example, each building image IM_{B} represents only one building. In another example, at least one building image IM_{B} represents several buildings.

The roof category C_{R} is chosen among a predetermined list of categories. Each roof category C_{R} implies specific installation constraints for the installation of photovoltaic panels on a roof R belonging to the roof category C_{R}.

Preferably, the predetermined list of categories comprises at least the following categories: concrete-gravel flat roof, steel roof, roof made in fiber cement without asbestos, roof made in fiber cement with asbestos, tiles roof, and flat roofs. The list of categories might also comprises only some of the above categories, or other additional categories.

In an example, the specific installation constraints for each roof category C_{R} of the predetermined list of categories comprise at least a constraint relative to:
- the hanging system of the photovoltaic panel on the roof R, and/or
- a treatment to be carried out on the roof R before the installation of the photovoltaic panels.

For example, in the case of tiles roofs, the installation constraints comprise a constraint of using fixing clamps to fix the photovoltaic panels.

For example, in the case of roofs made in fiber cement with asbestos, the installation constraints comprise a constraint of removing the asbestos from the roof R before installing the photovoltaic panels.

In an example of embodiment, the building phase 100 comprises the following steps 100A to 100D which are illustrated on figure 3.

Step 100A is a step of collecting input data. The input data comprise input images IM seen from the sky of areas comprising buildings having roofs R, and a roof mask M_{R} for each building of each input image IM.

In an example, the roof mask(s) M_{R} are considered as being the ground surface of the building, the ground surface being a known data.

In another example, the roof mask(s) M_{R} are obtained by a segmentation performed on the input image IM to highlight the roofs R. The segmentation is, for example, performed by an edge detection algorithm.

Step 100B is a step of cutting out the input images IM around each building, on the basis of the roof mask(s) M_{R} of the input images IM, so as to obtain an image for each building. Each obtained image forms a building image IM_{B}. Step 100B is possibly an optional step when the input images IM represent only one building.

Step 100C is a step of labelling each building image IM_{B} with a roof category C_{R}, the roof category C_{R} being selected among the predetermined list of categories.

In an example, the roof category C_{R} for each building image IM_{B} is obtained using a labelling tool T_{L}. The labelling tool T_{L} is an algorithm configured to display the building images IM_{B} on a display as well as the predetermined list of categories (for example superimposed on the building images IM_{B}), and to acquire the roof category C_{R} selected by a user among the predetermined list of categories. The labelling tool T_{L} renders easier the labelling of the building image IM_{B} and reduces the risks of errors.

In the example of figure 3, the labelling tool T_{L} displays three categories C1, C2, C3, and the selected category is C2.

Step 100D is a step of building the training database DB by associating each building image IM_{B} with the corresponding roof mask M_{R} and the obtained roof category C_{R}.

In a variant, at least one building image IM_{B} represents several buildings. The labelling tool T_{L} is configured to display the building images IM_{B} on a display as well as the predetermined list of categories, and to acquire the roof categories C_{R}, selected by a user for each roof, among the predetermined list of categories.

The determination method comprises a phase 200 of training a detection and classification model M on the basis of the training database DB so as to obtain a trained model M'. The training phase 200 is, for example, implemented by the calculator 20 interacting with the computer program product 22, that is to say is computer-implemented.

The input of the trained model M' is an image of an area seen from the sky. The trained model M' is configured for determining a roof mask M_{R} and a roof category C_{R} among the predetermined list of categories for each building imaged on the input image IM.

The detection and classification model M is a deep learning model.

Preferably, the detection and classification model M is a convolutional neural network (CNN).

Preferably, the detection and classification model M has been pretrained on a database different from the training database DB so as to achieve transfer learning.

The training technique is typically based on supervised learning, with training and validation substeps (performed by dividing the training database DB, for example 80% of the data for the training substep and 20% of the data for the validation substep).

In an example, the detection and classification model M is a mask Region-based Convolutional Neural Network (mask RCNN) with a Feature Pyramid Network (FPN) as backbone. The detection and classification model M is for example obtained from the Facebook Al computer vision tool Detectron 2.

Preferably, the trained model M' associates a confidence metric to each determined roof category C_{R}.

The determination method comprises a phase 300 of operating the trained model M'. The operating phase 300 is, for example, implemented by the calculator 20 interacting with the computer program product 22, that is to say is computer-implemented.

The operating phase 300 comprises the following steps:
- receiving an image of interest IM_{I} of an area seen from the sky, and
- determining, by the trained model M', a roof mask M_{R} and a roof category C_{R} for each building imaged on the image of interest IMi, the determined roof categories C_{R} indicating installation constraints for the installation of photovoltaic panels on the corresponding roofs R.

Preferably, the determination method also comprises a phase 400 of displaying, on a display (for example the display 34 of the calculator 20), the image of interest IM_{I} on which is superimposed the determined roof mask(s) M_{R} and a data indicative of the roof category C_{R} of each roof R. Preferably, if applicable, the confidence metric is also displayed on the display. Figure 3 illustrates an example of implementing phase 300.

Optionally, the determination method comprises a phase 500 of determining an arrangement A of photovoltaic panels on each roof R imaged on the image of interest IM_{I}. The determination phase 500 is, for example, implemented by the calculator 20 interacting with the computer program product 22, that is to say is computer-implemented.

The determination phase 500 comprises a step 500A of detecting obstacles O on each roof R of the image of interest IM_{I} by processing the image of interest IM_{I} using the corresponding roof mask(s) M_{R}. This enables to obtain an obstacle mask M_{O} for each roof R of the image of interest IM_{I}.

In an example of implementation, a target image IM_{T} is obtained by applying the corresponding roof mask(s) M_{R} on the image of interest IM_{I} so that only the roofs R are represented on the target image IM_{T}.

Then, a contour detection is performed on the target image IM_{T} to obtain a contour mask M_{C} for each roof R. The detected contours materialize obstacles O on the roof R. For example, the contour detection is performed by applying a Canny filter on the target image IM_{T}.

Thereafter, the obstacles O are highlighted on each roof R of the image of interest IM_{I} by combining the roof masks M_{R} and the contour masks Mc in order to obtain a mask of the obstacles O present on each roof R of the image of interest IM_{I}, called obstacle mask M_{O}.

The determination phase 500 comprises a step 500B of determining an arrangement A of photovoltaic panels on each roof R of the image of interest IM_{I} as a function of the corresponding obstacle mask M_{O} so that each photovoltaic panel covers a portion of the roof R that is free of obstacles O. In an example, step 500B comprises the positioning of representative shapes of photovoltaic panels on each roof R of the obstacle mask M_{O}, followed by the elimination of the shapes at least partially superimposed on an obstacle O. The determined arrangement A of photovoltaic panels matches the remaining shapes.

The steps 500A and 500B are materialized by the model M2 on figure 4.

Optionally, the determination phase 500 comprises a step 400C of displaying, on a display, the image of interest IM_{I} on which is superimposed the determined arrangement A of photovoltaic panels.

Optionally, the determination method comprises a phase 600 of determining solar data relative to the arrangement A of photovoltaic panels determined for each roof R of the image of interest IM_{I}. The determination phase 600 is, for example, implemented by the calculator 20 interacting with the computer program product 22, that is to say is computer-implemented.

In an embodiment, the solar data comprises at least one data among the solar potential of the arrangement A and the yield of the arrangement A. The solar potential is the solar power received on a zone in kilowatt per hour per year (kW/hours/year). The yield is the ratio between the energy produced (kWh) and the theoretical power (KWp) of the installation.

Optionally, the method comprises a phase of designing and/or manufacturing an arrangement A of photovoltaic panels corresponding to the panels of the determined arrangement A, possibly followed by the actual positioning of the photovoltaic panels on the roof(s) R of the studied area.

Hence, the above method enables to determine both the surface area of roofs R on an image as well as the category of the roof R. This enables to determine in a more precise way installation constraints for the installation of photovoltaic panels on a roof R of a building.

In addition, the prediction is fast, about one second to make a prediction on an image.

The person skilled in the art will understand that the embodiments and variants described above can be combined to form new embodiments provided that they are technically compatible.

## Claims

1. A method for determining installation constraints for the installation of photovoltaic panels on a roof (R) of a building, the method comprising the following phases which are computer-implemented:
- a phase of building a training database (DB), the training database (DB) associating an image seen from the sky of an area comprising at least one building having a roof (R), called building image (IM_{B}), with a roof mask (M_{R}) for each building of the building image (IM_{B}) and a roof category (C_{R}) for each building of the building image (IM_{B}), the roof category (C_{R}) being chosen among a predetermined list of categories, each roof category (C_{R}) implying specific installation constraints for the installation of photovoltaic panels,
- a phase of training a detection and classification model (M) on the basis of the training database (DB) so as to obtain a trained model (M'), the trained model (M) having as input an image of an area seen from the sky and being configured for determining a roof mask (M_{R}) and a roof category (C_{R}) among the predetermined list of categories for each building imaged on the input image (IM),
- a phase of operating the trained model (M') comprising the following steps:
• receiving an image of interest (IM_{I}) of an area seen from the sky, and
• determining, by the trained model (M'), a roof mask (M_{R}) and a roof category (C_{R}) for each building imaged on the image of interest (IM_{I}), the determined roof category(ies) (C_{R}) indicating installation constraints for the installation of photovoltaic panels on the corresponding roof(s).

2. A method according to claim 1, wherein the specific installation constraints for each roof category (C_{R}) of the predetermined list of categories comprise at least a constraint relative to:
- the hanging system of the photovoltaic panel on the roof (R), and/or
- a treatment to be carried out on the roof (R) before the installation of the photovoltaic panels.

3. A method according to claim 1 or 2, wherein the method comprises a phase of displaying, on a display, the image of interest (IM_{I}) on which is superimposed the determined roof mask(s) (M_{R}) and a data indicative of the roof category (C_{R}) of each roof (R).

4. A method according to any one of claims 1 to 3, wherein the trained model (M') associates a confidence metric to each determined roof category (C_{R}).

5. A method according to any one of claims 1 to 4, wherein the phase of building the training database (DB) comprises the following steps :
• collecting input data comprising: input images (IM) seen from the sky of areas comprising buildings having roofs (R), and a roof mask (M_{R}) for each building of each input image (IM),
• cutting out the input images (IM) around each building, on the basis of the roof mask(s) (M_{R}) of the input images (IM), so as to obtain an image for each building, each obtained image forming a building image (IM_{B}),
• labelling each building image (IM_{B}) with a roof category (C_{R}), the roof category (C_{R}) being selected among a predetermined list of categories, and
• building the training database (DB) by associating each building image (IM_{B}) with the corresponding roof mask (M_{R}) and the obtained roof category (CR).

6. A method according to any one of claims 1 to 5, wherein the roof category (C_{R}) for each building image (IM_{B}) is obtained using a labelling tool (T_{L}), the labelling tool (T_{L}) being configured to display the building image (IM_{B}) on a display as well as the predetermined list of categories and to acquire the roof category (C_{R}) selected by a user among the predetermined list of categories.

7. A method according to any one of claims 1 to 6, wherein, the predetermined list of categories comprises at least the following categories: concrete-gravel flat roof, steel roof, roof made in fiber cement without asbestos, roof made in fiber cement with asbestos, tiles roof, and flat roofs.

8. A method according to any one of claims 1 to 7, wherein the method comprises a phase of determining an arrangement (A) of photovoltaic panels on each roof (R) imaged on the image of interest (IM_{I}), the determination phase comprising:
- a step of detecting obstacles (O) on each roof (R) of the image of interest (IMi) by processing the image of interest (IM_{I}) using the corresponding roof mask(s) (M_{R}), to obtain an obstacle mask (M_{O}) for each roof (R) of the image of interest (IM_{I}), and
- a step of determining an arrangement (A) of photovoltaic panels on each roof (R) of the image of interest (IM_{I}) as a function of the corresponding obstacle mask (M_{O}) so that each photovoltaic panel covers a portion of the roof (R) that is free of obstacles (O).

9. A method according to claim 8, wherein the phase of determining an arrangement (A) of photovoltaic panels comprises displaying, on a display, the image of interest (IM_{I}) on which is superimposed the determined arrangement (A) of photovoltaic panels.

10. A method according to claim 8 or 9, wherein the method comprises a phase of determining solar data relative to the arrangement (A) of photovoltaic panels determined for each roof (R) of the image of interest (IM_{I}).

11. A method according to any one of claims 1 to 10, wherein the building images (IM_{B}) and the images of interest (IM_{I}) are images in the visible range acquired by a camera mounted on an aircraft.

12. A method according to any one of claims 1 to 11, wherein the detection and classification model (M) is a convolutional neural network.

13. A method according to any one of claims 1 to 12, wherein the detection and classification model (M) has been pretrained on a database different from the training database (DB) so as to achieve transfer learning.

14. A computer program product comprising a readable information carrier having stored thereon a computer program comprising program instructions, the computer program being loadable onto a data processing unit and causing a method according to any one of claims 1 to 13 to be carried out when the computer program is carried out on the data processing unit.

15. A readable information carrier on which a computer program product according to claim 14 is stored.
